# DEMANDE DE BREVET EUROPEEN

(11) **EP 0 712 171 A1**
(43) Date de publication de la demande: **15.05.1996**
(21) Numéro de dépôt: 95402483.2
(22) Date de dépôt: 07.11.1995
(51) Int. Cl.: H01L 51/30, H05B 33/14, C09K 11/06

(54) **Diode électroluminescente à base de polymère réticulé et polymère greffé électroluminescent**

(30) Priorité: 08.11.1994 FR 9413377
(71) Demandeur: THOMSON-CSF, F-75008 Paris (FR)
(72) Inventeur: Berdague, Philippe, F-92402 Courbevoie Cedex (FR); Le Barny, Pierre, F-92402 Courbevoie Cedex (FR)
(74) Mandataire: Guérin, Michel

(57) **Abrégé**

L'invention concerne une diode électroluminescente comprenant une couche à base de polymère réticulé dans lesquels sont dissous ou sur lesquels sont greffés des groupements électroluminescents. Elle comprend également une couche capable d'assurer le transport d'électrons. L'invention concerne également de nouveaux copolymères à chaînes latérales comprenant des groupements réticulables et des groupements électroluminescents.

Application : Affichage

## Description

Le domaine de l'invention est celui des diodes électroluminescentes à base de matériaux organiques, et plus précisément à base de matériaux polymères.

De telles diodes peuvent avantageusement être utilisées dans des écrans électroluminescents qui répondent actuellement au besoin en dispositifs d'affichage d'images complexes en couleurs.

En effet, dans ce domaine les tubes cathodiques, malgré leurs nombreux avantages souffrent d'un certain nombre de limitations comme leur encombrement ou la difficulté d'obtenir des écrans plats de grande dimension (supérieure au m). Alors que les écrans électroluminescents possèdent une supériorité au niveau de la compacité, de la légèreté ou bien encore au niveau de la possibilité d'obtenir des images lumineuses ayant un très grand contraste et un grand angle de vue.

Actuellement, seuls des matériaux électroluminescents inorganiques sont utilisés. Mais les matériaux électroluminescents organiques sont l'objet de la plus grande attention de l'homme de l'art, grâce en particulier à leur facilité de mise en oeuvre.

L'utilisation des matériaux organiques dans de tels dispositifs n'est pas une idée récente.

En effet, dès le début des années 60, un grand nombre de matériaux organiques étaient connus pour leurs rendements de fluorescence très importants, parfois proche de 100 %, dans l'ensemble du spectre visible, incluant la région du bleu. Des diodes réalisées à partir de cristaux d'anthracène permettent d'obtenir une lumière bleue, objectif essentiel de telles recherches dans la mesure où les performances des composés inorganiques phosphorés sont les moins bonnes dans cette région spectrale. Cependant, le développement de ces dispositifs ne pouvait être envisagé en raison des tensions trop importantes nécessaires pour injecter les charges (de l'ordre de 100 V).

Suite aux travaux de Vincett (P.S. Vincett, W.A. Barlow, R.A. Hann, G.G. Roberts ; Thin Solid Films, 94, (1982), 171), qui utilisait des films minces d'anthracène évaporés, ces tensions furent ramenées à 30 V. Puis Tang et Van Slyke réussirent à baisser ces tensions en dessous de 10 V, en incorporant une couche de transport de trous entre l'anode et la couche émettrice (C.W. Tang, S.A. Van Slyke ; Appl. Phys. Lett., 51 (12), (1987), 913-915). A de telles valeurs de tension, il devenait concevable de réaliser des diodes organiques électroluminescentes qui puissent concurrencer les dispositifs à base de matériaux minéraux existants. Mais la tendance des couches émettrices à recristalliser au cours du temps s'accompagnant d'une perte importante d'efficacité conduit aujourd'hui à s'orienter vers d'autres types de matériaux organiques.

C'est pourquoi, l'invention propose un nouveau type de diode électroluminescente à base de matériau organique, conçue pour être stable dans le temps (éviter tout phénomène de recristallisation), facile de réalisation et performante au niveau des phénomènes d'électroluminescence. Plus précisément, la diode selon l'invention comprend une couche assurant le transfert d'électrons entre une électrode appelée cathode et une couche électroluminescente à base de polymère réticulé capable également de véhiculer les trous, depuis une autre électrode appelée anode. En effet, généralement les matériaux électroluminescents organiques peuvent présenter des difficultés à transporter les électrons, et l'on choisit de recourir à une couche spécifique capable de véhiculer les électrons. Pour assurer une facilité de mise en oeuvre, les différentes couches sont à base de polymère permettant la réalisation de films minces. En effet, la technique généralement utilisée pour élaborer des fines couches à base de polymère consiste à dissoudre du polymère dans un solvant adapté puis à procéder à l'enduction sur un substrat et enfin évaporer le solvant. L'emploi de polymère réticulable chargé de molécules électroluminescentes greffées ou non sur le polymère présentent deux avantages. D'une part les molécules actives dispersées n'ont pas tendance à cristalliser comme dans l'art antérieur, ce qui conduit à des diodes électroluminescentes stables dans le temps. D'autre part, les couches à base de polymère pouvant être réticulées ne sont pas susceptibles d'être dissoutes et donc détériorées par des dépôts successifs d'autres solutions à base de polymère en vue d'élaborer une succession de couches présentant les fonctions recherchées.

Plus précisément l'invention a pour objet une diode électroluminescente comprenant un substrat recouvert d'une anode, une cathode, plusieurs couches de matériaux organiques à base de polymère, caractérisée en ce qu'elle comprend sur l'anode une couche électroluminescente comportant un polymère réticulé et une couche comprise entre la couche électroluminescente et la cathode, capable de véhiculer des électrons.

La diode électroluminescente selon l'invention peut avantageusement comprendre deux couches élémentaires C_{1A} et C_{1B}, la couche C_{1A} déposée sur l'anode étant capable de véhiculer des trous et comportant du polymère réticulé, la couche C_{1B} étant électroluminescente et comportant également du polymère réticulé.

La couche électroluminescente peut avantageusement comprendre une matrice de polymère réticulé dans laquelle sont dissoutes des molécules électroluminescentes.

La couche électroluminescente peut avantageusement comprendre un copolymère à chaînes latérales dans lequel certaines chaînes latérales sont réticulées, d'autres chaînes latérales comportant des groupements électroluminescents.

L'invention a aussi pour objet un nouveau type de copolymère électroluminescent répondant à la formule chimique suivante : 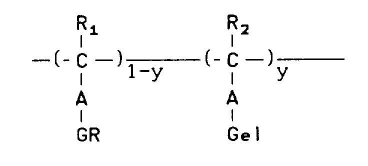 avec y fraction molaire 0 < y < 1
si A : -COO-
alors

R₁ : H ; CH₃ ; F

R₂ : H ; CH₃ ; F

Si A : 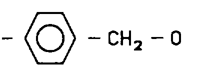 R₁ = R₂ = H

GR groupement réticulable thermiquement de type : 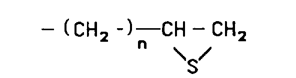 ou - (CH₂ 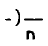 NH₂ avec 2 < n < 10
ou

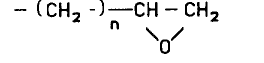

Gel groupement électroluminescent de type 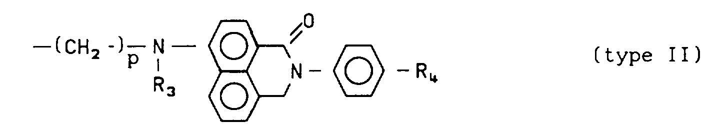 avec

R₃ : C_{w}H_{2w+1} 1 ≤ w ≤ 10

R₄ : C_{q}H_{2q+1} 1 ≤ 9 ≤ 10

2 ≤ p < 10

y peut avantageusement être supérieur à environ 0,4 pour obtenir un effet électroluminescent satisfaisant.

La couche C₂ capable d'assurer le transport d'électrons peuvent avantageusement comprendre un polymère dans lequel sont dissoutes ou greffées des molécules de type :

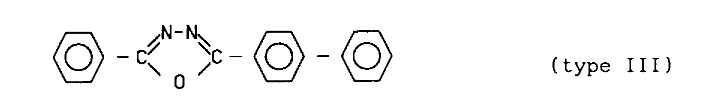

La couche C_{1A} capable d'assurer le transport de trous peuvent avantageusement comprendre un polymère réticulé avec des groupements dissous ou greffés de type amines aromatiques et plus particulièrement de type

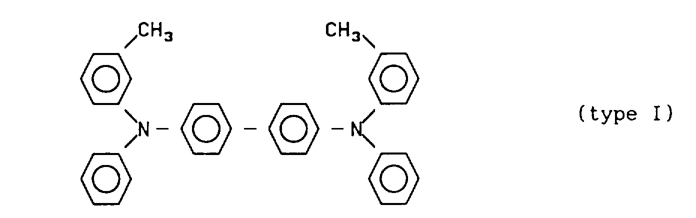

L'invention sera mieux comprise et d'autres avantages apparaîtront à la lecture de la description qui va suivre et des figures annexées parmi lesquelles :
- la figure 1 schématise une diode électroluminescente selon l'invention ;
- la figure 2 illustre le schéma réactionnel de synthèse d'un exemple de polymère réticulable, utilisé dans une diode selon l'invention ;
- la figure 3 illustre le schéma réactionnel conduisant à un type de molécule pouvant être utilisé dans la couche électroluminescente ;
- la figure 4 illustre le schéma réactionnel de synthèse d'un copolymère électroluminescent et réticulable, selon l'invention.

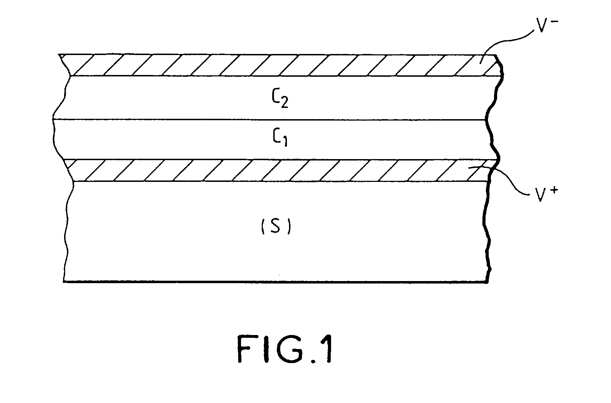

La diode électroluminescente selon l'invention comporte de préférence un substrat (S) recouvert d'une anode, au moins deux couches à base de polymère dont une est électroluminescente, déposées sur l'anode, lesdites couches étant recouvertes d'une cathode. La figure 1 schématise une telle configuration. Ainsi lorsque l'on fait passer un courant dans une telle structure en créant une différence de potentiel suffisante entre l'anode et la cathode,il y a injection d'électrons depuis la cathode, injection de trous depuis l'anode, dans la couche électroluminescente et une fraction de ceux-ci se recombinent et donnent par désexcitation d'une partie des excitons formés, des photons dont la longueur d'onde se trouve dans le visible.

L'anode est de préférence réalisée à partir d'un matériau conducteur de type oxyde d'indium et d'étain (ITO) en raison de son fort travail d'extraction et de sa transparence dans l'ensemble du spectre visible. On peut également la réaliser en polyanilyne.

La cathode est de préférence réalisée à partir d'un matériau très réducteur pour permettre l'injection d'électrons, ce matériau pouvant notamment être un métal tel que l'aluminium, le calcium ou l'indium.

Entre l'anode et cathode, il peut être particulièrement avantageux d'utiliser un ensemble de trois couches assurant respectivement les fonctions de transport de trous, d'électroluminescence et de transport d'électrons.

En effet, il a déjà été démontré que l'insertion de chacune de ces couches entraîne une augmentation significative des performances des diodes (C. Adashi, T. Tsutsui, S. Saito ; Appl. Phys. Lett, 55/15), (1989), 1489-1491). Car l'une des causes de desexcitations non radiatives des excitons est leur extinction aux électrodes. Ces couches extrêmes servent ainsi d'espaceurs entre les électrodes et la couche émettrice et permettent de confiner les excitons. Ainsi l'utilisation d'une couche de transport de trous, facilite l'injection des trous à partir de l'anode et diminue de façon significative la tension de travail. De même, l'utilisation d'une couche de transport d'électrons facilite l'injection et le transport des électrons, bloque les trous au niveau de la couche émettrice et contribue à y confiner les excitons.

Dans une structure performante, on peut ainsi superposer trois couches dont le contrôle des épaisseurs permet également de contrôler l'injection des électrons et des trous au niveau de la couche émettrice afin de les égaliser et d'optimiser ainsi le taux de recombinaison électrons-trous par charges injectées.

En utilisant des matériaux polymères pour réaliser de telles diodes électroluminescentes, il est important de contrôler les dépôts successifs des couches sans altérer les couches préalablement déposées. C'est pourquoi, la diode électroluminescente utilise nécessairement des polymères réticulables dans les couches destinées à être recouvertes par d'autres couches, en l'occurence la couche électroluminescente que l'on cherche à recouvrir d'une couche capable de véhiculer les électrons.

D'une manière générale, les différentes couches comprennent du polymère dans lequel on a dissous ou sur lequel on a greffé les fonctions recherchées (transport de trous, électroluminescence, transport d'électrons).

L'avantage des polymères sur lesquels sont greffées les fonctions réside dans les concentrations plus élevées que l'on est en mesure d'atteindre.

Dans tous les cas de figure, on procède à l'enduction d'une solution comprenant le polymère et ses groupements actifs, on procède ensuite à la réticulation de préférence thermique du polymère avant de procéder au dépôt d'une couche supérieure. Typiquement les différentes couches peuvent être élaborées à partir de solution d'environ 30 g/l comprenant du polymère. Lorsque le dépôt d'une solution (réalisé par dépôt à la tournette) est terminé, le film est séché puis chauffé sous vide de façon à ce que la réticulation se produise.

Ainsi, dans les exemples de diodes électroluminescentes, selon l'invention dans lesquels trois couches sont déposées successivement on réalise sur l'anode un premier dépôt d'un polymère réticulable dans lequel sont dissoutes des molécules de type (I). Les polymères réticulables utilisés peuvent répondre à la formule chimique générique suivante : 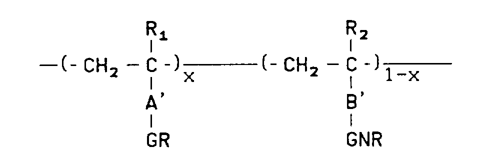
- Si: A' = -COO- :
- Alors: B' = -COO-
- R₁ = H ; F ; CH₃
- R₂ = H ; F ; CH₃
GR : 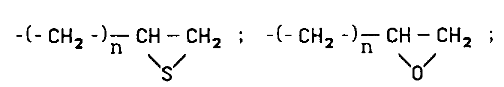 -(-CH₂ 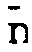 NH₂ avec 2<n<10
GNR : CₕH₂ₕ₊₁ ; 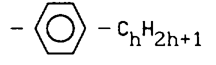 avec 0 ≤ h ≤ 10
Si A = 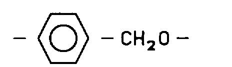 alors R₁ = R₂ = H
GR : 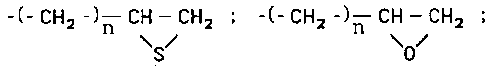 -(-CH₂ 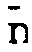 NH₂ avec 2<n<10
B' : 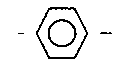 et GNR rien
B' : 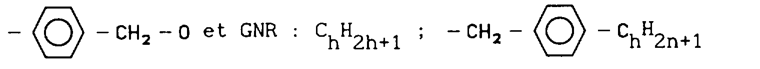 avec 0 ≤ h ≤ 10
* lorsque le groupement réticulable est de type 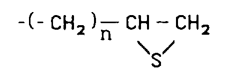 la réticulation thermique peut être assurée par un simple chauffage
* lorsque le groupement réticulable est de type 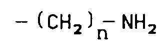 avec 2 < n < 10
   la réticulation thermique peut alors être réalisée par ajout dans la solution à enduire de molécules possédant plusieurs fonctions epoxy comme par exemple des molécules de type 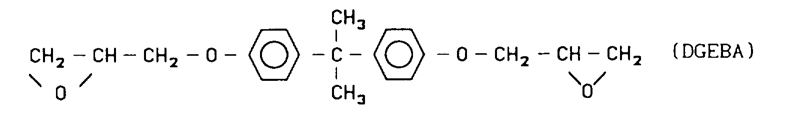 puis chauffage
* lorsque le groupement réticulable est de type 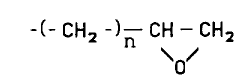 avec 2<n<10 la réticulation thermique peut être favorisée par l'ajout dans la solution d'enduction de molécules possédant plusieurs fonctions amine aliphatique comme par exemple des molécules de type :

   H₂N - CH₂ - CH₂ - NH - CH₂ - CH₂ - NH - CH₂ - CH₂ - NH₂ (TETA)

   puis chauffage. Cette couche peut aussi être réalisée à partir de copolymères comportant des groupements réticulables et des groupements assurant le transport de trous. Ce type de polymère peut typiquement être obtenu à partir de la copolymérisation d'un monomère 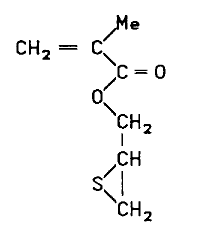 et d'un monomère

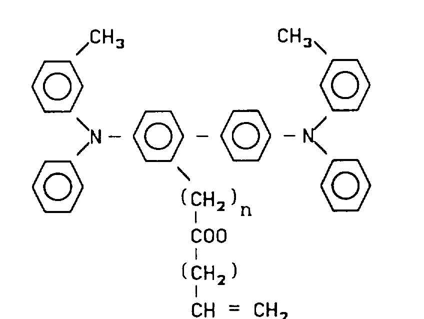

La couche C_{1A} étant ainsi réalisée, on procède dans un deuxième temps à l'élaboration de la couche C_{1B} électroluminescente, sans risque de dégradation au niveau de la couche C_{1A}.

Ainsi une solution de polymère réticulable comportant des molécules dissoutes ou des groupements greffés, électroluminescents est élaborée dans un solvant adéquat en vue d'élaborer la couche C_{1B}.

Les polymères employés dans le cas de matrice polymère comportant des molécules électroluminescentes peuvent typiquement répondre à la même formule chimique que celle des polymères utilisés dans la couche C_{1A}.

Les molécules électroluminescentes sont quant à elles choisies en fonction de la longueur d'onde que l'on cherche à obtenir. Ainsi on peut employer des molécules de type (II), on peut également recourir à des molécules possédant des chaînes aliphatiques plus longues (pour augmenter encore leur solubilité dans les solvants organiques) ; pour jouer sur la longueur d'onde d'émission, les substituants portés par les cycles aromatiques du côté de l'aniline ou du côté du naphtalène peuvent être modifiés.

Après réticulation de la couche C_{1B'} on réalise enfin la couche C₂ élaborée à partir de polymère et de molécules de type (III).

De manière générale la couche supérieure ne nécessite pas d'être réticulée dans la mesure où aucun dépôt ultérieur de solvant ne risque de la redissoudre, seul un dépôt métallique est effectué dans un dernier temps.

Le polymère utilisé dans cette couche C₂ peut donc être tout polymère choisi parmi le polyméthyl methacrylate : PMMA, le polycarbonate, le polystyrène PST.

Nous allons décrire un premier exemple de matériau pouvant être utilisé dans la couche électroluminescente.

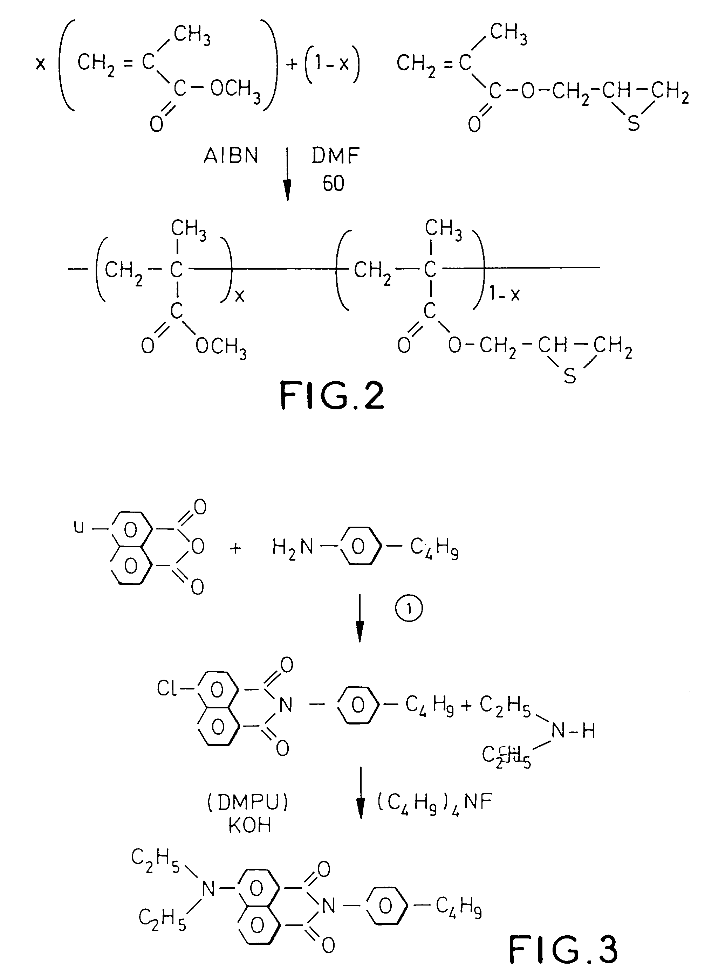

Il s'agit d'un polymère (PR) dans lequel sont dispersées des molécules électroluminescentes (ME). Le polymère (PR) répond à la formule chimique suivante : 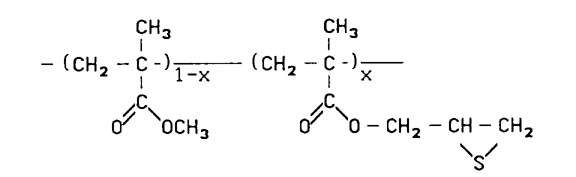 avec x fraction molaire comprise entre 0,2 et 0,3. Le schéma réactionnel conduisant à la synthèse de ce polymère est illustré en figure 2.

Dans une ampoule à vide sont mis en réaction 7,5 g (75 mmol) de méthacrylate de méthyle, 3,95 g (25 mmol) de méthacrylate d'épithioglycidyle et 0,1 g d'azobisisobutyronitrile (AIBN) dans 50 ml de toluène. Le mélange est dégazé sous vide puis l'ampoule est scellée. Le mélange est laissé sous agitation à 60°C pendant 12 heures. Après l'avoir refroidi, l'ampoule est ouverte et le mélange réactionnel est coulé dans 1 l de méthanol. Le précipité formé est filtré et rincé au méthanol.

Les molécules dissoutes dans le polymère (PR) répondent à la formule chimique suivante :

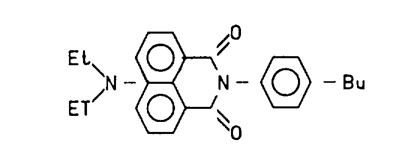

La synthèse de ce composé est illustrée en figure 3. Elle est initiée par la condensation de la 4-butyaniline sur la 4-chloro-1,8 anhydride-naphtalique en solution dans l'acide acétique (étape 1). Plus précisément, dans un ballon rodé de 500 ml, on dissout 11,6 g (50 mmol) de 4-chloro-1,8 anhydride-naphtalique et 14,9 g (100 mmol) de 4-butylaniline dans 250 ml d'acide acétique. le mélange réactionnel est maintenu à reflux pendant 12 heures sous agitation. Une fois la solution revenue à température ambiante un produit précipite. Le solide est filtré et recristallisé dans l'acétonitrile. On obtient 11,8 g de produit final soit un rendement de 65 %.

A partir de ce produit final on réalise la synthèse du N-(4-butylphenyl)-4(N,N-diethylamino)-naphtalimide (Etape 2) :

Dans un ballon de 50 ml, on dissout 3,62 g (10 mmol) de N-(4-butylphényl)-4-chloro-naphtalimide, 2,7 g (10 mmol) de fluorure de tétrabutylammonium et 1,46 g (20 mmol) de diéthyl-amine dans 20 ml de 1,3 Dimethyl - 3,4,5,6 - tetrahydro - 2 [1M] - pyrimidinome (DMPU). La solution est laissée sous agitation à 80°C pendant 12 h. Le mélange réactionnel est ensuite versé dans 500 ml d'eau. Le précipité formé est filtré, rincé à l'eau, séché et purifié par chromatographie sur colonne de silice avec comme éluant du chloroforme. On obtient 3,12 g (Rd = 78 %) de produit final.

Avant d'être utilisé comme molécule émettrice le N-(4-butylphényl)-4-(N,N-diéthylamino)-naphtalimide est purifié une deuxième fois par sublimation sous vide.

Nous allons décrire un deuxième exemple de matériau pouvant être utilisé dans la couche électroluminescente.

Il s'agit d'un copolymère (PER) comportant des fonctions réticulables et des groupements actifs en électroluminescence, émettant à 530 nm et répondant à la formule chimique suivante :

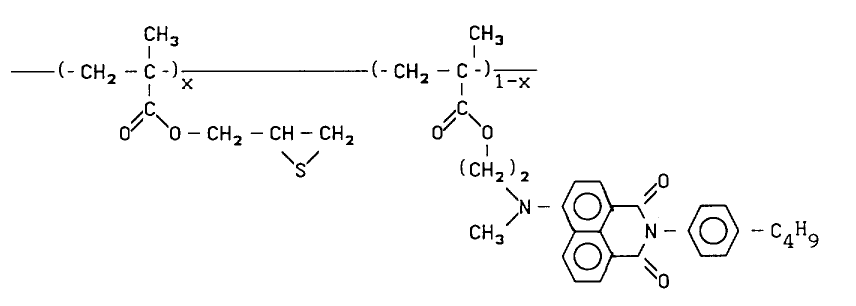

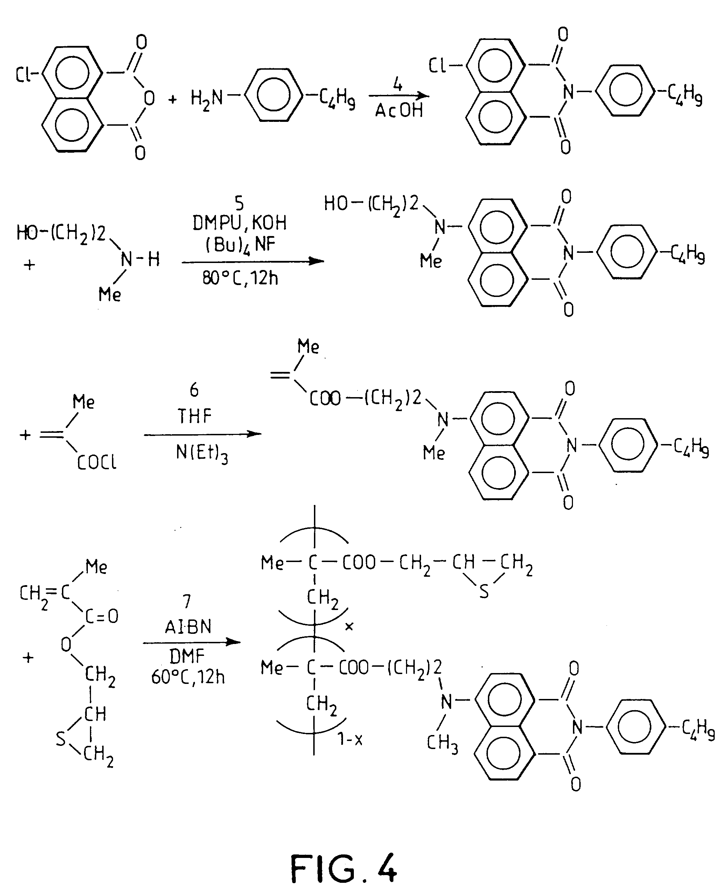

Le schéma réactionnel du copolymère (PER) est illustré en figure 4 et comprend quatre étapes principales détaillées ci-après.

### Etape 4 : Synthèse du N-4(butyl)-phényl)-4-chloronaphtalimide.

Cette étape est effectuée de la même façon que l'étape 1. D'autres anilines peuvent être utilisées ici de façon à faire varier la nature de la molécule émettrice finale. A titre d'exemple nous allons décrire la synthèse du N-(4-(butyl)-phényl)-4-chloronaphtalimide.

Dans un ballon rodé de 100 ml, on dissout 2,32 g (10 mmol) d'anhydride 4-chloronaphtalique et 2,98 g (20 mmol) de 4-(butyl)-aniline dans 50 ml d'acide acétique. Le mélange réactionnel est maintenu à reflux pendant 12 h sous agitation. Une fois la solution revenue à température ambiante un produit précipite. Le solide est filtré et recristallisé dans l'acétonitrile. On obtient 2,95 g (Rd = 78 %) de produit final.

Dans la suite de cette synthèse nous utiliserons le N-(4-butylphényl)-4-chloronaphtalimide comme produit initial.

### Etape 5 : Synthèse du N-(4-butylphényl)-4-(N-méthyl, N-(2-hydroxyéthyl)-amino)-naphtalimide.

Dans un ballon de 50 ml, on dissout 1,81 g (5 mmol) de N-(4-butylphényl)-4-chloro-naphtalimide, 1,35 g (5 mmol) de fluorure de tétrabutylammonium, 6,9 g (5 mmol) de K₂CO₃, 0,75 g (10 mmol) de 2-méthylamine-1-éthanol dans 20 ml de DMPU. La solution est laissée à 80°C pendant 12 h sous agitation. Le mélange réactionnel est ensuite versé dans 500 ml d'eau. Le précipité formé est filtré, rincé à l'eau et séché. On obtient 1,79 g (Rd = 89 %) de produit brut utilisé sans autre purification dans l'étape suivante.

### Etape 6 : Synthèse du méthacrylate d'éthyle-2-(4-(N-(4-butylphényl)-naphtalimidyl)-méthyl-amino).

Dans un bicol de 100 ml muni d'un réfrigérant surmonté d'une garde à chlorure de calcium et d'une ampoule à brome on dissout 1,79 g (4,7 mmol) de N-(4-butylphényl)-4-(N-méthyl, N-(2-hydroxyéthyl)-amino)-naphtalimide et 0,95 g (9,4 mmol) de triéthyl amine dans 50 ml de THF fraîchement distillé. On additionne goutte à goutte, sous agitation, une solution de 0,98 g (9,4 mmol) de chlorure de méthacryloyle (fraîchement distillé) dans 10 ml de THF. On laisse sous agitation à 40°C pendant 1 nuit. La solution est concentrée et le solide obtenu est purifié par chromatographie sur colonne de silice avec le dichlorométhane pour éluant suivie d'une recristallisation dans l'éthanol.
Rendement : 68,5 %
Point de fusion : 126,5°C.

### Etape 7 : Synthèse du copolymère (PER).

Dans une ampoule à vide sont mis en réaction 1 g (2,1 mmol) du monomère préparé précédemment 0,112 g (0,7 mmol) de méthacrylate d'épithioglycidyle et 0,01 g d'AIBN dans 10 ml de DMF. Le mélange est dégazé sous vide puis l'ampoule est scellée. Le mélange est laissé sous agitation à 60°C pendant 12 h. Après l'avoir refroidit l'ampoule est ouverte et le mélange réactionnel est coulé dans 1 l de méthanol. Le précipité formé est filtré et rincé au méthanol.
Rendement : 73 %
Température de transition vitreuse : 141,5°C
Teneur en monomètre émetteur : 75 % (déterminé par RMN)

## Revendications

1. Diode électroluminescente comprenant un substrat (S) recouvert d'une anode (A), une cathode (C), plusieurs couches de matériaux organiques à base de polymère, caractérisée en ce qu'elle comprend sur l'anode (A) une couche (C₁) électroluminescente comportant un polymère réticulé et une couche (C₂) comprise entre la couche (C₁) et la cathode, capable de véhiculer des électrons.

2. Diode électroluminescente selon la revendication 1, caractérisée en ce que la couche (C₁) est constituée de deux couches élémentaires (C_{1A}) et (C_{1B}), la couche (C_{1A}) déposée sur l'anode étant capable de véhiculer des trous et comportant du polymère réticulé, la couche (C_{1B}) étant électroluminescente et comportant également du polymère réticulé.

3. Diode électroluminescente selon l'une des revendications 1 ou 2, caractérisée en ce que la couche électroluminescente comprend du polymère à chaînes latérales réticulé au niveau desdites chaînes latérales et des molécules électroluminescentes dissoutes dans le polymère.

4. Diode électroluminescente selon la revendication 3, caractérisée en ce que le polymère à chaînes latérales est de type résine époxy-amine.

5. Diode électroluminescente selon la revendication 3, caractérisé en ce que le polymère à chaînes latérales est de type résine : 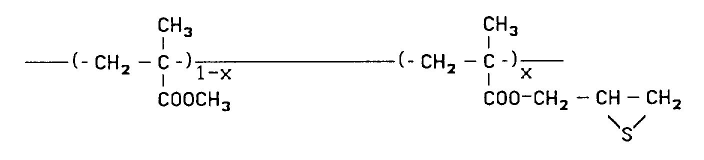 avec 0,2 < x < 0,3

6. Diode électroluminescente selon l'une des revendications 1 ou 2, caractérisée en ce que la couche électroluminescente comprend un polymère à chaînes latérales dont (1-y) pourcentage molaire de chaînes latérales comprend des fonctions réticulables et y pourcentage molaire de chaînes latérales comprend des groupements électroluminescents.

7. Diode électroluminescente selon la revendication 6, caractérisée en ce que y est supérieur à environ 0,4.

8. Diode électroluminescente selon l'une des revendications 6 ou 7, caractérisée en ce que la fonction réticulable est de type thiirane.

9. Diode électroluminescente selon l'une des revendications 6 ou 7, caractérisée en ce que la fonction réticulable est de type amine.

10. Diode électroluminescente selon l'une des revendications 6 ou 7, caractérisée en ce que la fonction réticulable est de type epoxy.

11. Diode électroluminescente selon l'une des revendications 1 à 10, caractérisée en ce que la couche (C_{1A}) comprend un polymère à chaînes latérales dont z pourcentage molaire de chaînes latérales comprend des fonctions réticulables et (1-z) pourcentage molaire de chaînes latérales comprend des fonctions permettant d'assurer le transport de trous.

12. Polymère à chaînes latérales pouvant être réticulé caractérisé en ce qu'il répond à la formule chimique suivante : 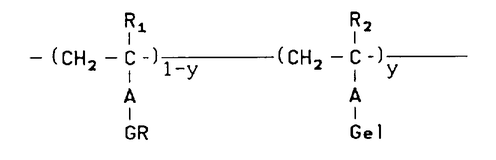 avec y fraction molaire 0 < y < 1
Si A = -COO- :
Alors R₁ = H ; F ; CH₃
R₂ = H ; F ; CH₃
Si A : 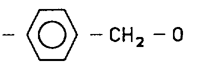 R₁ = R₂ = H
GR groupement réticulable de type 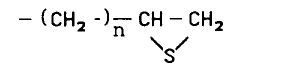 ou - (CH₂ 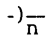 -NH₂ avec 2 < n < 10
ou 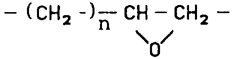 Gel groupement électroluminescent de type 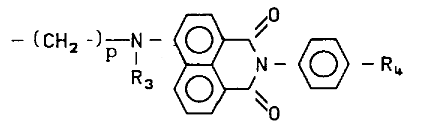
avec R₃ : C_{w}H_{2w+1} 1 ≤ w ≤ 10
R₄ : C_{q}H_{2q+1} 1 ≤ 9 ≤ 10
2 ≤ p < 10
1 ≤ w ≤ 10
1 ≤ q ≤ 10
